# EUROPÄISCHE PATENTSCHRIFT

(11) **EP 1 997 614 B1**
(45) Veröffentlichungstag und Bekanntmachung des Hinweises auf die Patenterteilung: **20.07.2011**
(21) Anmeldenummer: 08008979.0
(22) Anmeldetag: 15.05.2008
(51) Int. Cl.: B30B 7/02, B32B 37/10

(54) **Verfahren und Vorrichtung zum Laminieren von im Wesentlichen plattenförmigen Werkstücken unter Druck- und Wärmeeinwirkung**
Method and device for laminating mainly plate-shaped workpieces with the use of pressure and heat
Procédé et dispositif de laminage d'éléments essentiellement en forme de plaques sous l'effet de la chaleur et de la pression

(30) Priorität: 30.05.2007 DE 102007025380; 21.07.2007 DE 102007034135
(43) Veröffentlichungstag der Anmeldung: 03.12.2008
(73) Patentinhaber: Robert Bürkle GmbH, 72250 Freudenstadt (DE)
(72) Erfinder: Damm, Norbert, 76689 Karlsdorf-Neuthard (DE); Metzger, Dagmar, 76187 Karlsruhe (DE)
(74) Vertreter: Lemcke, Brommer & Partner

(56) Entgegenhaltungen:
- EP-A2- 1 609 597
- US-A- 5 593 532

## Beschreibung

Die Erfindung betrifft ein Verfahren zum Laminieren von im Wesentlichen plattenförmigen Werkstücken unter Druck- und Wärmeeinwirkung nach dem Oberbegriff des Anspruchs 1 sowie eine solche Vorrichtung nach dem Oberbegriff des Anspruchs 13. Die hierbei zu laminierenden Werkstücke sind mehrschichtig aufgebaut und enthalten mindestens eine Kleberschicht mit einem Kleber, der durch Wärmeeinwirkung aktiviert wird und aushärtet. Das bevorzugte Anwendungsgebiet der vorliegenden Erfindung ist das Laminieren von Photovoltaik-Modulen, bei denen eine Solarzellenschicht mit samt ihren elektrischen Kontaktierungselementen feuchtigkeitsdicht eingekapselt sowie wetterfest und dennoch lichtdurchlässig abgedeckt ist.

Im Rahmen der vorliegenden Erfindung wird eine Mehretagen-Vakuum-Laminierpresse mit mehreren Pressenetagen eingesetzt. In jeder Pressenetage ist eine Vakuumkammer vorgesehen, die von einem flexiblen Andrückmittel in eine Produkthälfte und eine Druckhälfte unterteilt wird. Die Produkthälfte der Vakuumkammer ist zur Aufnahme von mindestens einem Werkstück vorgesehen und evakuierbar, während die Druckhälfte der Vakuumkammer druckbeaufschlagbar ist. Das flexible Andrückmittel ist so ausgestaltet und angeordnet, dass es aufgrund eines durch Evakuieren der Produkthälfte und/oder durch ein zusätzliches Druckbeaufschlagen der Druckhälfte erzeugten Druckunterschieds in der Vakuumkammer das Werkstück direkt oder indirekt gegen eine Unterseite der Vakuumkammer presst.

Eine Mehretagen-Vakuum-Laminierpresse zum Laminieren von Photovoltaik-Modulen ist in der EP 1 609 597 A2 beschrieben. Diese Laminierpresse umfasst eine Anzahl von Heizplatten, zwischen denen jeweils eine Pressenetage gebildet ist. Oberhalb jeder Heizplatte, an der Unterseite der darüber angeordneten Heizplatte, ist jeweils ein Dichtrahmen angeordnet, welcher eine Vakuumkammer umschreibt, die bei geschlossener Pressenetage durch dichtes Auflegen des Dichtrahmens auf die darunterliegende Heizplatte evakuiert werden kann. Über den Dichtrahmen ist eine elastische Membran gespannt, die die Vakuumkammer in eine Produkthälfte und eine Druckhälfte unterteilt sowie als Andrückmittel dient, um den für die Laminierung des Photovoltaik-Moduls erforderlichen Druck gegen die Heizplatte aufzubringen. Hierfür wird das bei geschlossener Presse unter der Membran, zwischen dieser und der Heizplatte liegende Volumen, das die Produkthälfte der Vakuumkammer bildet, evakuiert, wodurch sich die Membran eng an das Werkstück anlegt. Bedarfsweise wird außerdem eine durch Abdichten des Dichtrahmens gegen die obere Pressenplatte gebildete, nach unten von der Membran begrenzte Druckhälfte der Vakuumkammer mit Druckluft beaufschlagt, um den Anpressdruck des Werkstücks noch zu erhöhen. Das Evakuieren der Produkthälfte ermöglicht ein blasenfreies Laminieren des Werkstücks, da etwa vorhandene Lufteinschlüsse und dergleichen noch vor Erreichen der Erweichungstemperatur des verwendeten Klebstoffs herausgezogen werden. Durch den Kontakt des Werkstücks mit der Heizplatte erwärmt sich ersteres allmählich bis über die Erweichungstemperatur und die Aushärtetemperatur der Kleberschichten, so dass der Laminierprozess bis zur vollständigen Aushärtung des Klebstoffs fortgesetzt werden kann.

Die Ausbeute an elektrischer Energie von Photovoltaik-Modulen hängt direkt von der Fläche ab. Dementsprechend beeinflusst die Verarbeitungskapazität pro Flächeneinheit bei zeitlich festgelegten Prozessen wie dem des Laminierens unmittelbar die Kosteneffizienz bei der Herstellung der Module. Daher ist es vorteilhaft, eine Mehretagen-Vakuum-Laminierpresse zu verwenden, bei der mehrere Pressenetagen übereinander angeordnet sind. Hierdurch erhöht sich die zu verarbeitende Flächenkapazität, ohne den Flächenbedarf am Produktionsstandort zu erhöhen.

Allerdings erhöht sich durch die mehretagige Ausbildung einer Laminierpresse der ohnehin schon hohe Energiebedarf beim Aufheiz- und Abkühlzyklus aufgrund der verringerten Wechselwirkung der einzelnen Heizplatten mit der Umgebung. Des Weiteren ist es mitunter schwierig, aufgrund der beengten Platzverhältnisse in einer Mehretagen-Laminierpresse die zur optimalen Temperaturführung notwendigen Heiz- und Kühlaggregate in erforderlicher Dimensionierung unterzubringen. Schließlich ist es im Hinblick auf eine weiter erhöhte Kosteneffizienz wünschenswert, die Taktzeiten beim Laminieren auch bei Verwendung einer Mehretagen-Laminierpresse weiter zu verringern, was aus den eben genannten Gründen nur in engen Grenzen dadurch erfolgen kann, dass die Aufheiz- und Abkühlzeiten verkürzt werden.

In der US-A-5,593,532 ist ein Verfahren und eine Vorrichtung zum Laminieren von Photovoltaik-Modulen offenbart, wobei die Photovoltaik-Module in einer ein-etagigen Vakuum-Laminierpresse vorlaminiert und dann in einem Zustand, in dem die wärmeaktivierbaren Kleberschichten der Photovoltaik-Module noch nicht ausgehärtet sind, in einen Aushärteofen verbracht werden, wo sie bei Aushärtetemperatur ausgehärtet werden.

Der vorliegenden Erfindung liegt die Aufgabe zugrunde, die vorgenannten Nachteile einer eingangs genannten Vorrichtung bzw. eines eingangs genannten Verfahrens zu vermeiden und die Effizienz des Laminiervorgangs mit einer Mehretagen-Laminierpresse weiter zu erhöhen.

Gelöst ist diese Aufgabe erfindungsgemäß durch ein Verfahren mit den Merkmalen des Anspruchs 1 sowie durch eine Vorrichtung mit den Merkmalen des Anspruchs 13.

Bevorzugte Ausgestaltungen des erfindungsgemäßen Verfahrens finden sich in den Ansprüchen 2 bis 12; bevorzugte Ausgestaltungen der erfindungsgemäßen Vorrichtung sind in den Ansprüchen 14 bis 22 niedergelegt.

Die vorliegende Erfindung zeichnet sich also dadurch aus, dass der Mehretagen-Vakuum-Laminierpresse mindestens ein Mehretagen-Laminator nachgeschaltet ist. Dieser enthält eine Anzahl von Laminatoretagen, in denen die Werkstücke mit einer Temperatur an oder oberhalb der Aushärtetemperatur der Kleberschichten beaufschlagt werden. Zum Überführen der Werkstücke von der Mehretagen-Vakuum-Laminierpresse zu dem mindestens einen Mehretagen-Laminator ist eine Transfereinrichtung vorgesehen. Im einfachsten Fall kann diese Transfereinrichtung dadurch gebildet sein, dass sowohl die Mehretagen-Vakuum-Laminierpresse als auch der Mehretagen-Laminator in jeder Etage mit einem Förderband zum Ein- und Ausfördern der Werkstücke versehen sind, wobei der Transfer der Werkstücke von der Mehretagen-Vakuum-Laminierpresse in den Mehretagen-Laminator durch direkte Übergabe von Förderband zu Förderband erfolgt, also keine zusätzliche zwischengeschaltete Übergabeeinrichtung notwendig ist. Hierzu müssen allerdings die Mehretagen-Vakuum-Laminierpresse und der Mehretagen-Laminator direkt hintereinander angeordnet sein.

In der Mehretagen-Vakuum-Laminierpresse werden nach der vorliegenden Erfindung die Werkstücke zunächst nur vorlaminiert, das heißt die Werkstücke werden zur Vermeidung einer Blasenbildung unter Vakuum gesetzt, mit einer Anpresskraft beaufschlagt und sodann erwärmt, bis die Kleberschichten soweit aktiviert worden sind, dass das Herausziehen von gasförmigen Bestandteilen abgeschlossen oder durch die Aktivierung der Kleberschicht zum Stillstand gekommen ist, und umgekehrt ein Eindringen von Luft von außen in das Werkstück bzw. zwischen dessen Schichten - was zur Luftblasenbildung führen würde - bei einer Belüftung der Vakuumkammer ausgeschlossen ist. Zu diesem Zeitpunkt des Laminierprozesses werden die Werkstücke aus der Mehretagen-Vakuum-Laminierpresse herausgenommen, da ein Weiterprozessieren, also ein Aushärten der Kleberschichten, nicht mehr weiter unter Vakuum erfolgen muss. Dies kann vielmehr der Mehretagen-Laminator übernehmen, der die Werkstücke mit einer Temperatur an oder oberhalb der Aushärtetemperatur der Kleberschichten beaufschlagt, ohne Vakuumkammern zu enthalten.

Insbesondere dann, wenn der Arbeitstakt des Vorlaminierens in der Mehretagen-Vakuum-Laminierpresse kürzer ist als der Arbeitstakt des Mehretagen-Laminators zum Aushärten der Kleberschichten, ist es vorteilhaft, mehr als einen Mehretagen-Laminator hinter die Mehretagen-Vakuum-Laminierpresse zu schalten: Beispielsweise kann der Aushärtetakt bei Verwendung von zwei Mehretagen-Laminatoren doppelt so lang sein, wie der Arbeitstakt der Mehretagen-Vakuum-Laminierpresse, ohne einen Leerlauf der Mehretagen-Vakuum-Laminierpresse in Kauf nehmen zu müssen.

Die Mehretagen-Laminatoren sind als Pressen ausgebildet, um das Aushärten der Kleberschichten nicht nur unter Temperatureinwirkung, sondern auch unter Druckeinwirkung ablaufen zu lassen und den Wärmeübergang von den Heizplatten auf die Werkstücke mittels Kontaktdruck zu verbessern.

Zur Vervollständigung des Laminierprozesses können nach dem Mehretagen-Laminator eine oder gegebenenfalls auch mehrere Mehretagen-Kühleinrichtungen zum Kühlen der Werkstücke auf eine Temperatur unterhalb der Erweichungstemperatur der Kleberschichten vorgesehen sein. Diese Kühleinrichtungen sind vorzugsweise als Pressen ausgebildet, um die Werkstücke mittels Kontaktdruck an Kühlplatten abzukühlen.

Zum Laminieren von Photovoltaik-Modulen werden hoch adhäsive Kleber verwendet. Insbesondere dann, wenn die flexiblen Andrückmittel in den Vakuumkammern der Mehretagen-Vakuum-Laminierpresse wie üblich als Membrane beispielsweise aus Silikon oder Gummi ausgestaltet sind, welche jeweils auf einen in jeder Etage der Mehretagen-Vakuum-Laminierpresse vorgesehenen Dichtrahmen gespannt sind, sind solch hoch adhäsive Klebstoffe jedoch problematisch. Denn Klebstoffreste an der Membran, welche diese unbrauchbar machen können oder zumindest das Arbeitsergebnis verschlechtern, können bei mehretagigen Laminierpressen kaum mit vertretbarem Aufwand von der Membran entfernt werden. Im Stand der Technik werden daher Trennfolien verwendet, die oberhalb und unterhalb der Werkstücke angeordnet werden und das Anhaften von Klebstoffresten an Heizplatten und Membranen der Mehretagen-Vakuum-Laminierpresse verhindern. Die Verwendung von Trennfolien erfordert jedoch wiederum Handarbeit vor und nach der Mehretagen-Vakuum-Laminierpresse, so dass diese kaum in eine vollautomatisch ablaufende Prozesslinie mit vollautomatischer Beschickung und Entnahme der Werkstücke eingebunden werden kann.

Der große Vorteil der vorliegenden Erfindung in diesem Zusammenhang besteht darin, dass es möglich ist, das Vorlaminieren in der Mehretagen-Vakuum-Laminierpresse unter solch niedrigen Temperaturen ablaufen zu lassen, dass die Kleberschichten zwar erweichen bzw. mit einer Erweichung beginnen, dass diese sich jedoch nicht soweit verflüssigen, dass zu besorgen ist, dass Klebstoffrückstände an die Membran oder die Heizplatte gelangen. Dementsprechend kann auf Trennfolien verzichtet werden. Das Aushärten im erfindungsgemäß nachgeschalteten Mehretagen-Laminator erfolgt dann zwar bei Aushärtetemperatur der Kleberschichten, jedoch gibt es in den Mehretagen-Laminatoren keine weichelastische Membran, die von Klebstoffrückständen befreit werden müsste, um deren Funktion nicht zu beeinträchtigen.

Ganz Allgemein liegt ein großer Vorteil der erfindungsgemäßen Verfahrensweise und der entsprechenden Vorrichtung darin, dass die Temperaturführung in den einzelnen Stationen, also der Mehretagen-Vakuum-Laminierpresse, dem Mehretagen-Laminator und gegebenenfalls weiteren Mehretagen-Laminatoren unabhängig voneinander erfolgen können, so dass das Zusammenspiel von Erwärmung und Druck viel individueller gesteuert werden kann, als wenn der gesamte Laminierprozess in einer einzigen Mehretagen-Vakuum-Laminierpresse durchgeführt wird. Beispielsweise kann in der Mehretagen-Vakuum-Laminierpresse die Zieltemperatur viel höher als die Aushärtetemperatur gewählt werden, um ein schnelles Erwärmen der Werkstücke zu gewährleisten, wobei in diesem Fall der Prozess entsprechend frühzeitig unterbrochen werden sollte. Umgekehrt kann jedoch die Zieltemperatur in der Mehretagen-Vakuum-Laminierpresse deutlich geringer als die Aushärtetemperatur der Kleberschichten gewählt werden, so dass die Erwärmung der Werkstücke langsamer erfolgt - soweit dies erwünscht ist - und gleichzeitig der Energieeinsatz minimiert wird.

In entsprechender Weise kann der Laminierprozess unter dem Aspekt der eingesetzten Energie sowie im Hinblick auf eine optimierte Temperaturführung dadurch verbessert werden, dass mehrere Mehretagen-Laminatoren hintereinandergeschaltet werden, deren Zieltemperaturen von Laminator zu Laminator variieren, insbesondere ansteigen.

Zur Regelung der Wärmeeinleitung in die Werkstücke können in der Mehretagen-Vakuum-Laminierpresse und/oder im Mehretagen-Laminator und/oder in der Mehretagen-Kühlpresse den Werkstücken Druckkissen oder Polster unterlegt und/oder die Werkstücke mit solchen abgedeckt werden. Hierbei ist es für deren Wirkung unerheblich, ob solche Druckkissen oder Polster ortsfest in den Maschinen eingebaut oder lose mit den Werkstücken die Prozessräume verbracht werden. Zur weiteren Beeinflussung der Temperaturführung im Werkstück können hierbei Druckkissen oder Polster verwendet werden, die über definierte Wärmeleit-Eigenschaften verfügen und den Wärmeübergang dementsprechend definiert verzögern.

Besondere Vorteile ergeben sich im Rahmen der vorliegenden Erfindung, wenn die Mehretagen-Vakuum-Laminierpresse eine Anzahl von übereinander angeordneten, gegeneinander bewegbaren Heizplatten und eine Anzahl von um die Heizplatten umlaufenden Förderbändern mit jeweils einem Obertrum und einem Untertrum aufweisen, ohne dass eine Membran als flexibles Andrückmittel vorgesehen ist. Vielmehr werden hierbei die Vakuumkammern in jeder Etage einerseits durch die obere Heizplatte und andererseits im wesentlichen durch das Obertrum des unteren Förderbandes begrenzt. Zwischen den Heizplatten und den Förderbändern sind Dichtungselemente, insbesondere Dichtungsrahmen, zur Abdichtung der Vakuumkammern nach außen vorgesehen. Das Untertrum des oberen Förderbandes fungiert dann als flexibles Andrückmittel, das eine untere Produkthälfte der Vakuumkammer von einer oberen Druckhälfte derselben trennt. Die in einem Dichtungsrahmen eingespannte Membran entfällt daher vollständig; deren Funktion wird durch die umlaufenden Förderbänder zusätzlich übernommen. Da die Förderbänder umlaufend ausgestaltet sind, ist eine Reinigung derselben von außerhalb der Pressenetagen sehr leicht möglich, so dass auch deshalb auf eine Trennfolie verzichtet werden kann. Es ist sogar möglich, eine herkömmliche Mehretagenpresse zu einer solcher Art ausgestalteten Mehretagen-Vakuum-Laminierpresse umzurüsten, indem Dichtungselemente, insbesondere Dichtungsrahmen, zur Ausbildung von Vakuumkammern nachgerüstet werden. Dies insbesondere direkt an einer Heizplatte, so dass das zugeordnete Förderband über den Dichtungselementen verläuft und somit beide Förderbänder benachbarter Heizplatten die gebildete Vakuumkammer durchlaufen.

Die Heizplatten sind hierfür vorzugsweise mit Ausnehmungen bzw. Vertiefungen versehen, so dass die Dichtungselemente nicht unbedingt die Form eines Rahmens aufweisen müssen und dennoch genügend Volumen in den Vakuumkammern vorhanden ist. Die obere Heizplatte kann an ihrer Unterseite mit einer Ausnehmung versehen sein, oder die untere Heizplatte an ihrer Oberseite, oder aber beide Heizplatten einer Pressenetage können Ausnehmungen aufweisen. Die Kontur der Vakuumkammern kann also in die Oberseiten und/oder Unterseiten der Heizplatten eingearbeitet sein, einschließlich der erforderlichen Dichtungen, soweit nicht die Förderbänder selbst gegen die Umgebung der Kammern in den Heizplatten abdichten. Alternativ oder zusätzlich sind auch aufgesetzte Dichtrahmen möglich, um die Vakuumkammern und deren Abdichtungen zu bilden.

Weitere Vorteile ergeben sich bei solch einer bevorzugten Ausgestaltung der Mehretagen-Vakuum-Laminierpresse, wenn die Obertrums der Förderbänder andere Materialeigenschaften als die Untertrums aufweisen. Denn die Obertrums der Förderbänder dienen zum aufliegenden Transport der zu laminierenden Werkstücke, während die Untertrums zumindest dann, wenn die Förderbänder zum Ein- und Ausfördern der Werkstücke jeweils einen ganzen Umlauf um die Heizplatte ausführen, lediglich zur Vervollständigung der Förderbänder und nicht direkt zum Transport der Werkstücke dienen. Dementsprechend können die Untertrums weicher und elastischer ausgebildet sein und so in ihrer Funktion als Andrückmittel beim Laminieren optimiert sein.

Bei einer solch unterschiedlichen Ausbildung der Obertrums und Untertrums der Förderbänder ist allerdings jeweils ein ganzer Umlauf der Förderbänder zum Ein- und Ausfördern der Werkstücke, also eine halbe Leerfahrt zwischen dem Ausfördern und dem Einfördern von Werkstücken notwendig. Um dennoch das erfindungsgemäße Hintereinanderschalten einer Mehretagen-Vakuum-Laminierpresse und eines oder mehrerer Mehretagen-Laminatoren zu ermöglichen, werden zunächst die Werkstücke aus dem letzten Mehretagen-Laminator ausgefördert, dann in einem zweiten Schritt die Werkstücke aus dem davorgeschalteten Mehretagen-Laminator bzw. aus der Mehretagen-Vakuum-Laminierpresse in den nachgeschalteten Mehretagen-Laminator überführt und erst zum Schluss neue Werkstücke in die Mehretagen-Vakuum-Laminierpresse eingefördert, so dass der halbe, "leere" Umlauf am Ende der Produktlinie beginnt und nach vorne an den Anfang der Produktlinie, in die Mehretagen-Vakuum-Laminierpresse durchgereicht wird.

Ausführungsbeispiele der vorliegenden Erfindung werden im Folgenden anhand der beigefügten Zeichnungen näher beschrieben und erläutert. Es zeigen:
- Figur 1: eine schematische seitliche Teildarstellung einer geöffneten Mehr-etagen-Vakuum-Laminier-Presse;
- Figur 2: eine schematische seitliche Teildarstellung einer geschlossenen Mehretagen-Vakuum-Laminierpresse;
- Figur 3: eine schematische seitliche Darstellung einer erfindungsgemäß ausgebildeten Produktlinie aus einer Mehretagen-Vakuum-Laminierpresse, einem Mehretagen-Laminator und einer Mehretagen-Kühleinrichtung nebst Beschickungs- und Entnahmevorrichtungen;
- Figur 4: eine Darstellung wie Figur 3, jedoch während des Arbeitstaktes, also bei geschlossenen Pressen;
- Figur 5: eine unvollständige seitliche Darstellung einer geöffneten Mehretagen-Vakuum-Laminierpresse;
- Figur 6: eine Darstellung wie Figur 5, jedoch im geschlossenen Zustand;
- Figur 7: ein Diagramm verschiedener Parameter der prozessierten Werkstücke über der Zeit in einer Mehretagen-Vakuum-Laminierpresse nach dem Stand der Technik;
- Figur 8: ein Diagramm wie Figur 7, jedoch mit einem erfindungsgemäß aufgeteilten Prozess in einer Mehretagen-Vakuum-Laminierpresse und zwei nachgeschalteten Mehretagen-Laminatoren;
- Figur 9: eine Darstellung wie in Figur 8, jedoch mit anderen Randbedingungen;
- Figur 10: eine Ergänzung der Figuren 8 und 9 durch eine Mehretagen-Kühleinrichtungs-Station;
- Figur 11: eine schematische Darstellung einer erfindungsgemäß ausgestalteten Produktionslinie;
- Figur 12: eine schematische Darstellung einer Variation einer erfindungsgemäß ausgestalteten Produktionslinie;
- Figur 13: schematische seitliche Darstellungen von zu laminierenden Werkstücken;
- Figur 14: eine schematische seitliche Teildarstellung wie Figur 1, jedoch einer anderen Ausführung;
- Figur 15: eine schematische seitliche Teildarstellung wie Figur 1, jedoch einer weiteren Ausführung.

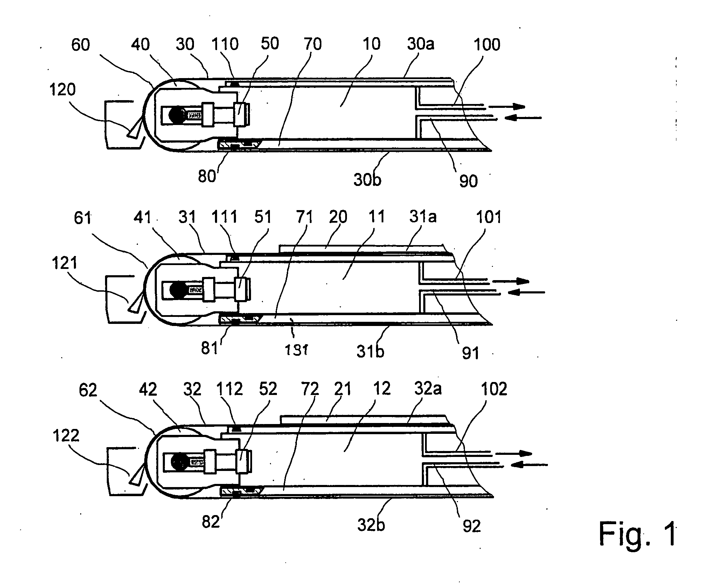

Figur 1 zeigt eine schematische seitliche Teildarstellung von drei Heizplatten 10, 11, 12 einer Mehretagen-Vakuum-Laminierpresse mit einer Vielzahl von Heizplatten. Die hier dargestellten drei Heizplatten 10, 11, 12 bilden zwischen sich zwei Pressenetagen, in denen sich jeweils ein zu laminierendes Werkstück 20, 21 befindet.

Um die Heizplatten 10, 11, 12 läuft jeweils ein Förderband 30, 31, 32 um, und zwar um Umlenkrollen 40, 41, 42, die über jeweils eine Kolben-Zylinder-Einheit 50, 51, 52 an den Stirnseiten der Heizplatten 10, 11, 12 befestigt sind und durch Heranfahren an diese Stirnseiten die Förderbänder 30, 31, 32 entspannen können und umgekehrt. Die Förderbänder 30, 31, 32 bestehen jeweils aus einem als Transportband ausgebildeten Obertrum 30a, 31 a, 32a und einem demgegenüber elastischer und breiter ausgebildeten Untertrum 30b, 31 b, 32b, welche beiden Teile mit zwei lösbaren Bandverbindern 60, 61, 62 (von denen in dieser Darstellung naturgemäß jeweils nur einer sichtbar ist) miteinander verbunden sind.

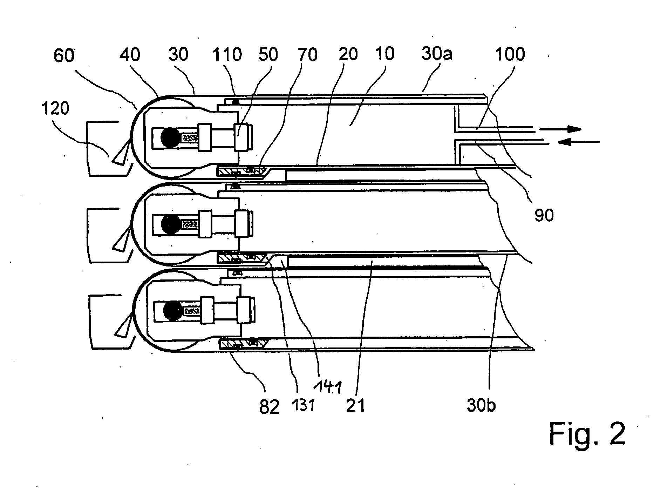

Zur Bildung der Vakuumkammern in den einzelnen Etagen der teilweise dargestellten Mehretagen-Vakuum-Laminierpresse sind zwischen den Obertrums 30a, 31a, 32a der Förderbänder 30, 31, 32 und den Oberseiten der Heizplatten 10, 11, 12 jeweils Dichtrahmen 110, 111, 112 angebracht, während zwischen den Untertrums 30b, 31b, 32b und den Unterseiten der Heizplatten 10, 11, 12 jeweils obere Dichtrahmen 80, 81, 82 angebracht sind, die sich bei geschlossener Presse (Figur 2) an die unteren Dichtrahmen 110, 111, 112 anpressen. Die hierdurch gebildeten gasdichten Vakuumkammern werden jeweils durch ein Untertrum 30b, 31 b, 32b in eine Produkthälfte 141 und eine Druckhälfte 131 unterteilt, wobei die Werkstücke 20, 21 unterhalb der Untertrums 30b, 31 b, 32b in den Produkthälften 141 der Vakuumkammern zu liegen kommen.

Die an die Produkthälften angrenzenden Oberseiten der Heizplatten 10, 11, 12 sind im vorliegend dargestellten Ausführungsbeispiel eben ausgestaltet und mit hier nur symbolisch dargestellten Absaugöffnungen 100, 101, 102 versehen, um den Produktraum zwischen dem Obertrum 31 a eines unteren Förderbandes 31 und dem Untertrum 30b eines oberen Förderbandes 30 evakuieren zu können. Zu diesem Zweck sind die Obertrums 30a, 31 a, 32a der unteren Förderbänder 30, 31, 32 schmaler ausgebildet als die Untertrums 30b, 31 b, 32b, so dass seitlich neben den Obertrums 30a, 31 a, 32a eine Verbindung zwischen den Produkträumen und den Oberseiten der Heizplatten 10, 11, 12 innerhalb der Dichtrahmen 80, 81, 82, 110, 111, 112 gegeben und die Produkthälften 141 der Vakuumkammern gebildet sind. Dementsprechend kann beispielsweise über die Absaugöffnung 102 eine Evakuierung der Produkthälfte 141 und insbesondere des Produktraums durch die Heizplatte 12 erfolgen, wodurch eine Blasenbildung beim Laminieren verhindert wird.

In die Unterseiten der Heizplatten 10, 11, 12 sind jeweils Ausnehmungen 70, 71, 72 eingearbeitet, so dass sich in Verbindung mit den Dichtrahmen 80, 81, 82 oberhalb der Untertrums 30b, 31 b, 32b jeweils eine Druckhälfte 131 der Vakuumkammern bildet. Diese Druckhälfte kann über symbolisch dargestellte Druckleitungen 90, 91, 92 mit Druckgas beaufschlagt, oder im einfachsten Fall auch nur belüftet werden, so dass sich die Untertrums 30b, 31 b, 32b aufgrund des in der Produkthälfte herrschenden Vakuums, gegebenenfalls unterstützt durch einen in der Druckhälfte herrschenden Überdruck, dicht an die Werkstücke 20, 21 anlegen und diese gegen die Heizplatten 11, 12 drücken. Die Untertrums 30b, 31 b, 32b der Förderbänder sind relativ breit gehalten, so dass sie die Dichtrahmen 80, 81, 82 rundum und gasdicht überdecken.

Die Kolben-Zylinder-Einheiten 50, 51, 52 an den Stirnseiten der Heizplatten 10, 11, 12 ermöglichen, die Spannung der Förderbänder und somit insbesondere die Spannung der Untertrums 30b, 31 b, 32b zu verändern. Beispielsweise wird dann eine hohe Förderbandspannung eingestellt, wenn die Werkstücke 20, 21 ein- oder ausgefördert werden, wohingegen beim Schließen der Presse und insbesondere während des Laminiervorgangs mit Evakuieren und Druckbeaufschlagen der Vakuumkammern eine Entspannung der Förderbänder 30, 31, 32 vorteilhaft ist: Die Werkstücke 20, 21 legen sich dann aufgrund der verringerten Spannung der Obertrums 31 a, 32a leichter auf die Oberseiten der Heizplatten 11, 12 auf, während die Untertrums 30b, 31 b einer Verformung durch Vakuum und gegebenenfalls Überdruck weniger Widerstand entgegensetzen.

An den Umlenkrollen 40, 41, 42 jedes Förderbandes 30, 31, 32 ist außerdem jeweils eine Reinigungsvorrichtung 120, 121, 122 vorgesehen, beispielsweise eine rotierende Reinigungsbürste oder - wie hier dargestellt - eine Rakel. Beim Ausfahren der Werkstücke 20, 21 nach dem Öffnen der Mehretagen-Vakuum-Laminierpresse bewegen sich die Untertrums 30b, 31 b, 32b der Förderbänder 30, 31, 32 an den Reinigungsvorrichtungen 120, 121, 122 vorbei und werden dort von etwaigen Klebstoffresten befreit. Wenn die Werkstücke 20, 21 ausgefahren sind, liegen die Untertrums 30b, 31 b, 32b jeweils an der Oberseite der Heizplatten 10, 11, 12, so dass nochmals ein halber Umlauf der Förderbänder 30, 31, 32 als Leerfahrt nötig ist, um ein Einfahren von weiteren Werkstücken zu ermöglichen. Hierbei bewegen sich dann auch die Obertrums 30a, 31 a, 32a der Förderbänder 30, 31, 32 an den Reinigungsvorrichtungen 120, 121, 122 vorbei, so dass auch diese von etwaigen Klebstoffresten befreit werden.

In Figur 2 ist die Mehretagen-Vakuum-Laminierpresse aus Figur 1 in ähnlicher teilweiser Darstellung - wiederum lediglich symbolisch - dargestellt, allerdings im geschlossenen Zustand. Wie anhand dieser Zeichnung verdeutlicht wird, legen sich die Untertrums 30b, 31 b, 32b der Förderbänder 30, 31, 32 beim Schließen der Mehretagen-Vakuum-Laminierpresse auf die Obertrums 30a, 31 a, 32a der jeweils unterhalb liegenden Förderbänder bzw. auf die zwischenliegenden Werkstücke 20, 21 auf. Gleichzeitig dichten die Dichtelemente 80, 81, 82 einerseits und 110, 111, 112 andererseits mit den dazwischenliegenden Förderbändern 30, 31, 32 rundum ab, um in jeder Pressenetage eine Vakuumkammer zu bilden. Diese Vakuumkammern werden von den Untertrums 30b, 31 b, 32b der Förderbänder gasdicht unterteilt, und zwar in eine obere Druckhälfte 131 und eine untere Produkthälfte 141. Nachdem die Produkthälfte 141 der Vakuumkammern über die Leitungen 100, 101, 102 evakuiert wurden, werden die Druckhälften 131 der Vakuumkammern über die Leitungen 90, 91, 92 mit Druckluft beaufschlagt. Das teflonisierte, wenig elastische, dünne Untertrum 30b eines Förderbandes 30 übernimmt im vorliegenden Ausführungsbeispiel also statt einer elastischen Membran die Funktion des Andrückmittels beim Vorlaminieren des Werkstücks 20.

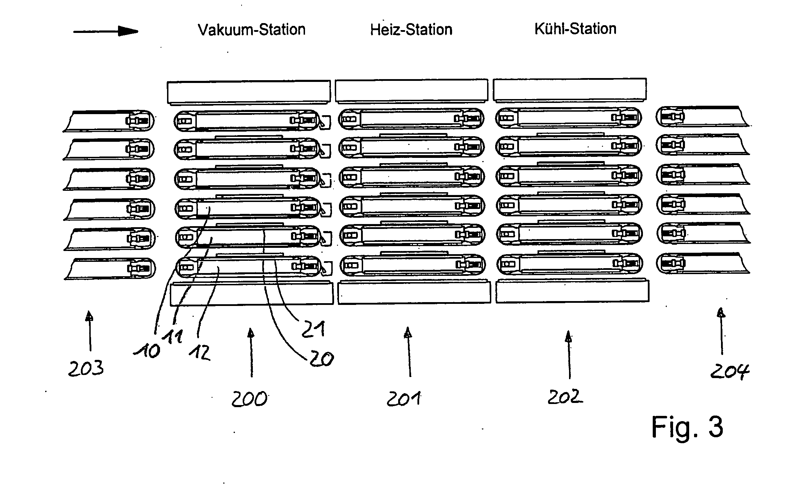

Figur 3 zeigt in einer schematischen seitlichen Darstellung ein Ausführungsbeispiel für eine erfindungsgemäße Vorrichtung zum Laminieren von Photovoltaik-Modulen, die in drei Stationen aufgeteilt ist, nämlich eine Mehretagen-Vakuum-Laminierpresse 200, einen Mehretagen-Laminator 201 und eine Mehretagen-Kühlvorrichtung 202. Vor der Mehretagen-Vakuum-Laminierpresse 200 und nach der Mehretagen-Kühleinrichtung 202 sind jeweils mehretagige Beschickungs- bzw. Entladevorrichtungen 203, 204 vorgesehen, um die Werkstücke 20, 21 in die Mehretagen-Vakuum-Laminierpresse 200 einzufördern bzw. aus der Mehretagen-Kühleinrichtung 202 auszufördern.

Sowohl die Mehretagen-Vakuum-Laminierpresse 200 als auch der Mehretagen-Laminator 201 und die Mehretagen-Kühleinrichtung 202 sind als mehretagige Pressen ausgebildet, wobei die jeweiligen Heiz- bzw. Kühlplatten jeweils mit einem umlaufenden Förderband versehen sind. Diese umlaufenden Förderbänder bilden die Transfereinrichtung zum Überführen der Werkstücke von der Mehretagen-Vakuum-Laminierpresse in den Mehretagen-Laminator und die Mehretagenkühleinrichtung, wobei die Werkstücke 20, 21 direkt, ohne Zwischenschaltung einer separaten Transfereinrichtung, von einer Station zur nächsten übergeben werden. Dementsprechend sind die drei gezeigten Stationen platzsparend unmittelbar hintereinander angeordnet. Da in der Mehretagen-Vakuum-Laminierpresse wie oben beschrieben die Untertrums der Förderbänder anders ausgebildet sind als die Obertrums der Förderbänder, ist ein halber Umlauf des Förderbandes als Leerfahrt notwendig, um nach dem Ausfördern der Werkstücke 20, 21 wieder neue Werkstücke einfördern zu können. Im Mehretagen-Laminator 201 und in der Mehretagen-Kühleinrichtung 202 kann es ebenfalls vorgesehen sein, solch eine Leerfahrt durchzuführen, beispielsweise um die Förderbänder zu reinigen. Dementsprechend wird bei der in Figur 3 dargestellten Vorrichtung am Ende jedes Arbeitstaktes zunächst ein Ausfördern der Werkstücke aus der Mehretagen-Kühleinrichtung 202 in die Entladevorrichtung 204 vorgenommen, die Leerfahrt der Mehretagen-Kühleinrichtung 202 durchgeführt und erst dann die Überführung von Werkstücken aus dem Mehretagen-Laminator 201 in die Mehretagen-Kühleinrichtung 202 gestartet. Danach wird die gegebenenfalls vorgesehene Leerfahrt des Mehretagen-Laminators 201 durchgeführt, bevor die vorlaminierten Werkstücke 20, 21 aus der Mehretagen-Vakuum-Laminierpresse ausgefördert und in den Mehretagen-Laminator 201 übergeben werden. Nach wiederum der erforderlichen Leerfahrt der Mehretagen-Vakuum-Laminierpresse 200 werden schließlich von der Beschickungsvorrichtung 203 neue Werkstücke in die Mehretagen-Vakuum-Laminierpresse eingefördert. Diese Vorgehensweise gleicht also einem Fehlstellen- oder Löchertransport von elektrischen Ladungsträgern in einem Halbleiterkristall.

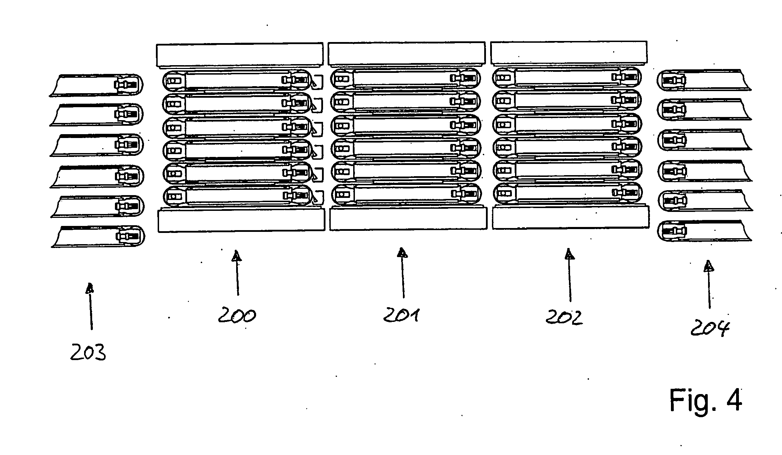

Figur 4 ist eine gegenüber Figur 3 leicht geänderte Darstellung desselben Ausführungsbeispiels, wobei hier sowohl die Mehretagen-Vakuum-Laminierpresse 200 als auch der Mehretagen-Laminator 201 und die Mehretagen-Kühleinrichtung 202 geschlossen sind. Es handelt sich also um die Darstellung des Arbeitstaktes der getaktet betriebenen Vorrichtung. An dieser Stelle sei angemerkt, dass eine getaktete Arbeitsweise der erfindungsgemäßen Vorrichtung zwar bevorzugt, jedoch nicht zwingend ist. Es ist im Rahmen der vorliegenden Erfindung auch nicht zwingend, dass sämtliche Pressenetagen einer der Pressen gleichzeitig geöffnet und geschlossen werden, die Pressenetagen können vielmehr grundsätzlich auch gruppenweise oder individuell betrieben werden.

Die Werkstücke 20, 21 werden erfindungsgemäß nur in der Mehretagen-Vakuum-Laminierpresse 200 mit Vakuum beaufschlagt. Der Mehretagen-Laminator 201 und die Mehretagen-Kühleinrichtung 202 sind jeweils als Presse ausgebildet, um den Wärmeübergang zu einerseits den Heizplatten sowie andererseits den Kühlplatten mittels Kontaktdruck zu verbessern. Eine Druckbeaufschlagung im Mehretagen-Laminator 201 unterstützt gleichzeitig die Aushärtung der Kleberschichten in den Werkstücken.

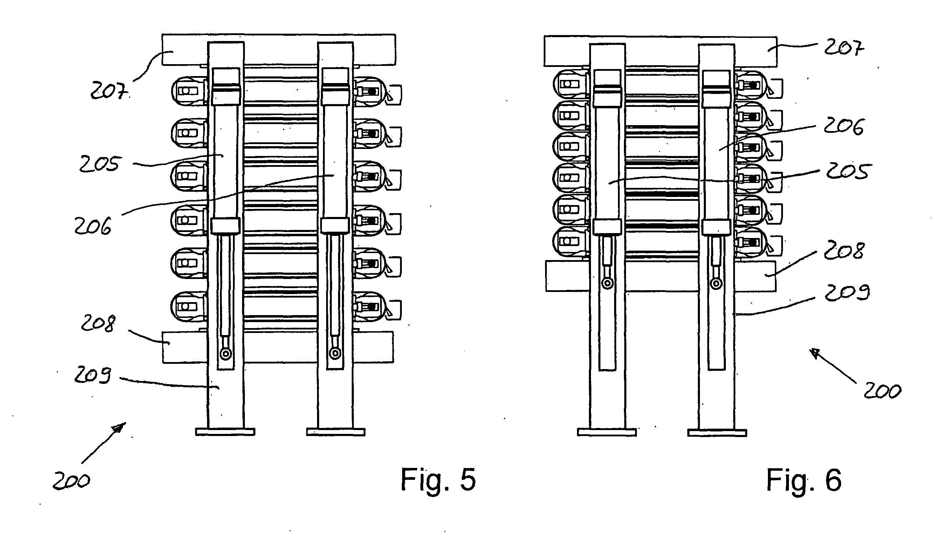

Die Figuren 5 und 6 zeigen eine vervollständigte Darstellung der Mehretagen-Vakuum-Laminierpresse 200 im geöffneten (Figur 5) und geschlossenen (Figur 6) Zustand. Mittels jeweils zweier Hydraulikzylinder 205, 206, die jeweils einerseits an einem oberen Druckbalken 207 und einem unteren, gegen ein Gestell 209 beweglichen Druckbalken 208 befestigt sind, können die oberen und unteren Druckbalken 207, 208 gegeneinander bewegt werden, um so die Presse zu schließen und zu öffnen. Dementsprechend werden im vorliegenden Ausführungsbeispiel sämtliche Pressenetagen sequentiell geöffnet und geschlossen.

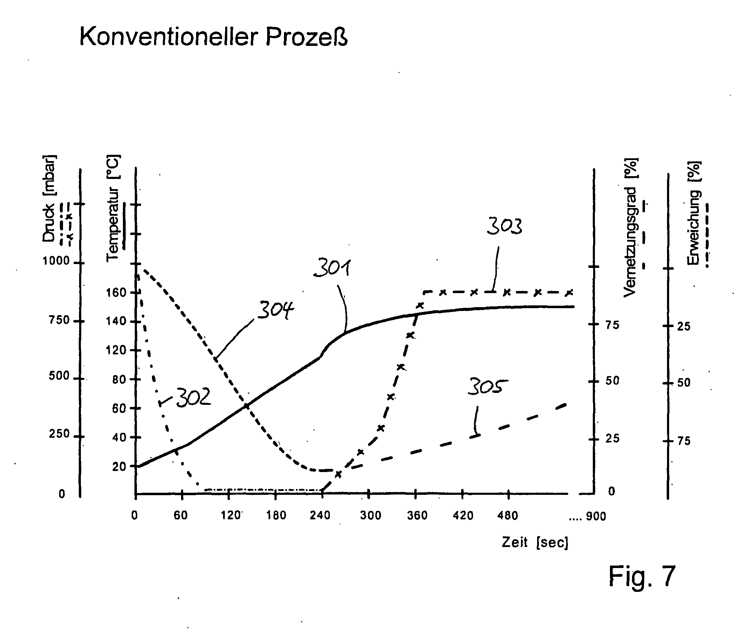

Figur 7 zeigt ein Diagramm verschiedener Randbedingungen eines konventionellen Prozesses in einer Mehretagen-Vakuum-Laminierpresse. Gemäß dem Stand der Technik werden hier die Werkstücke bis zur Aushärtung der Kleberschichten in der Mehretagen-Vakuum-Laminierpresse prozessiert. Die durchgezogene Linie 301 zeigt die Temperatur im Werkstück an, während die strichpunktierte Linie 302 in der ersten Hälfte des Diagramms den Luftdruck in der Produkthälfte der Vakuumkammer und in der zweiten Hälfte als Linie 303 den auf das Werkstück einwirkenden Kontaktdruck darstellt, im Falle der Linie 302 direkt als Gasdruck in mbar und im Falle der Linie 303 äquivalent zum Gasdruck in mbar eingetragen. Als Folge dieser Randbedingungen (Druck und Temperatur) ergeben sich die gestrichelt eingezeichneten Linien 304 und 305, wobei die Linie 304 die Erweichung der Kleberschichten in % anzeigt, während die Linie 305 den Vernetzungsgrad der Kleberschichten, hier eines vernetzenden Klebstoffs, darstellt.

Wie anhand dieses Diagramms erkennbar, erhöht sich die Temperatur der Werkstücke entlang der Linie 301 beginnend von Raumtemperatur (20 °C) bis zur Zieltemperatur (ca. 150 °C), wobei der Anstieg der Linie 301 vom Wärmeübergang zwischen den Heizplatten und den Werkstücken abhängt.

Anhand der schnell abfallenden Linie 302 wird verdeutlicht, dass die Produkthälfte der Vakuumkammer möglichst schnell evakuiert wird, bevor sich die Werkstücke nennenswert erwärmen. Bereits bei einer Werkstücktemperatur unter 50 °C ist der Druck in der Vakuumkammer auf nahezu 5 mbar abgesenkt, so dass eine Blasenbildung in den Kleberschichten vermieden wird. Die Erweichung (Linie 304) der Kleberschichten nimmt entsprechend der Zunahme der Werkstücktemperatur 301 zu. Bei Erreichen einer Temperatur von etwa 120 °C und eines Erweichungsgrades von über 80 %, wird die Druckhälfte der Vakuumkammer belüftet, so dass das Andrückmittel, das die Druckhälfte von der (weiterhin evakuierten) Produkthälfte der Vakuumkammer trennt, einen ansteigenden Anpressdruck auf das Werkstück ausübt. Dies wird mit der Linie 303 verdeutlicht. Im vorliegenden Fall wird die Druckhälfte der Vakuumkammer lediglich belüftet, jedoch nicht mit einem zusätzlichen Druck beaufschlagt, so dass der resultierende, auf das Werkstück wirkende Anpressdruck (Linie 303) leicht unterhalb des Atmospährendrucks bleibt. Mit dem ansteigenden Druck (303) und der ansteigenden Temperatur (301) nimmt der Vernetzungsgrad (305) der Kleberschichten zu, so dass eine Aushärtung erfolgt. Der durch das Belüften der Druckhälfte der Vakuumkammer entstehende Kontaktdruck des Werkstücks gegen die Heizplatte erhöht naturgemäß den Wärmeübergang in das Werkstück, wodurch die Temperatur (301) schneller ansteigt, bis sie sich abflachend der Zieltemperatur annähert.

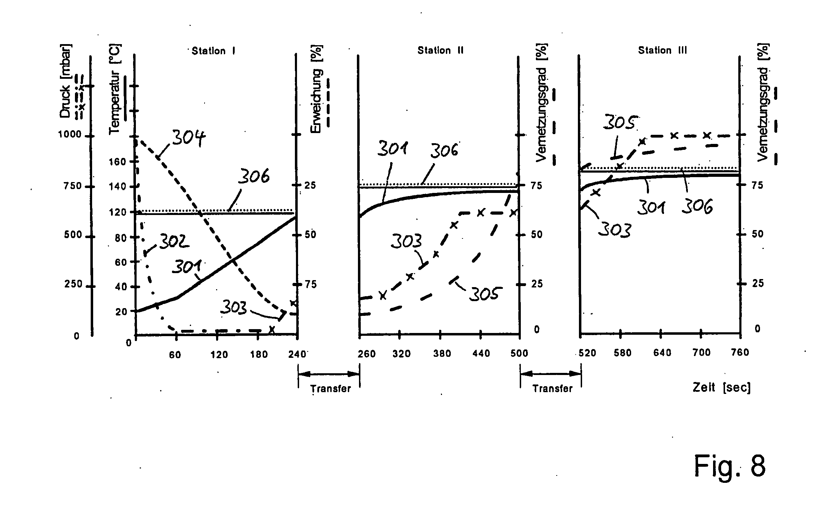

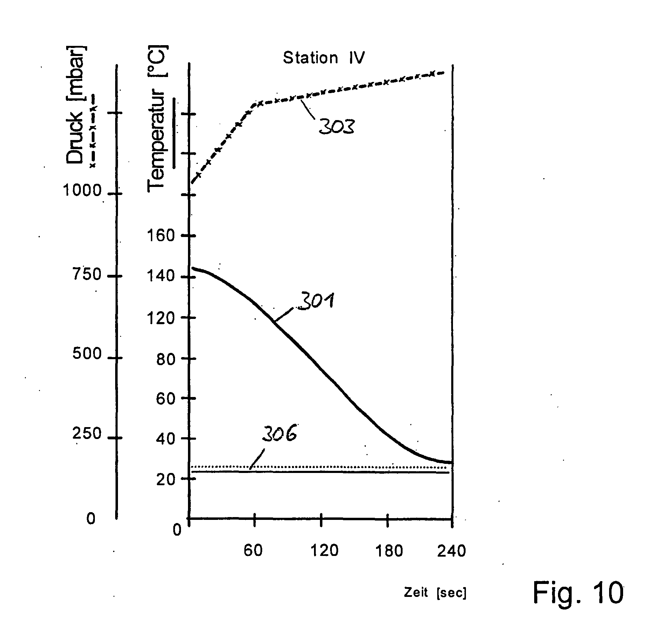

Demgegenüber zeigt Figur 8 ein erstes Beispiel für einen erfindungsgemäß aufgeteilten Prozess, wobei Station I die Mehretagen-Vakuum-Laminierpresse, Station II der Mehretagen-Laminator und Station III ein zweiter Mehretagen-Laminator symbolisiert. Die Mehretagen-Kühleinrichtung ist als Station IV in Figur 10 dargestellt.

Wie anhand Figur 8 deutlich wird, wird auch hier in der Station I der Druck in der Produkthälfte der Vakuumkammer (Linie 302) möglichst rasch abgesenkt, um eine Blasenbildung in den Kleberschichten zu verhindern. Da der Prozess erfindungsgemäß auf mehrere Stationen verteilt ist, muss jedoch die Zieltemperatur nicht wie im konventionellen Prozess an oder oberhalb der Aushärtetemperatur der Kleberschichten liegen, sondern kann niedriger gewählt werden. Vorliegend liegt die Zieltemperatur bei 120 °C, was durch eine Doppellinie 306 verdeutlicht ist.

Durch die herabgesetzte Zieltemperatur 306 erwärmt sich das Werkstück langsamer, was in einer flacheren Temperaturkurve 301 resultiert. Dementsprechend erfolgt auch die Erweichung 304 der Kleberschichten langsamer, so dass das Evakuieren des Produktraums (Linie 302) noch vor einer nennenswerten Erweichung der Kleberschichten vollzogen werden kann.

Die Aushärtung der Kleberschichten erfolgt sodann stufenweise in den Stationen II und III, also in zwei hintereinandergeschalteten Mehretagen-Laminatoren. Im ersten Mehretagen-Laminator (Station II) liegt die Zieltemperatur 306 immer noch gegenüber der Aushärtetemperatur auf abgesenktem Niveau, vorliegend auf ca. 140 °C, so dass sich die Temperatur 301 nur langsam, und erst in der zweiten Stufe in Station III der Zieltemperatur 150 °C annähert.

Da die Mehretagen-Laminatoren der Stationen II und III als Heißpressen ausgestaltet sind, kann der auf die Werkstücke einwirkende Anpressdruck, wie die Linie 303 zeigt, zur optimalen Vernetzung (Linie 305) geregelt werden. Durch zunächst nur einseitiges Belüften der Druckhälfte der Vakuumkammer in Station I und erst nachfolgend beidseitiges Belüften zum Öffnen der Mehretagen-Vakuum-Laminierpresse, wird im Übrigen bereits in Station I ein gewisser Anpressdruck - Linie 303 - auf das Werkstück ausgeübt.

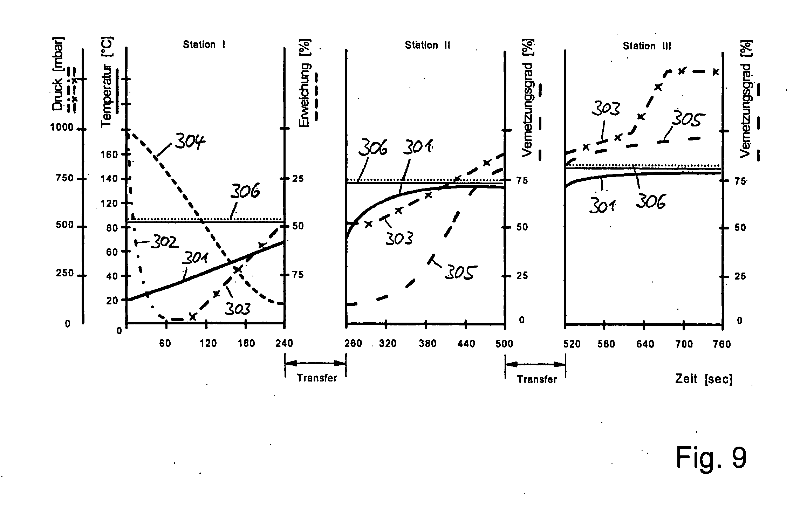

In Figur 9 wird ein weiteres Beispiel der Prozessführung im erfindungsgemäßen Verfahren gezeigt, das dem in Figur 8 dargestellten Beispiel entspricht, jedoch hinsichtlich der Prozessparameter anders ausgestaltet ist. Hier wird insbesondere in Station III ein höherer Anpressdruck auf die Werkstücke aufgebracht, während die Zieltemperaturen wie im Beispiel nach Figur 8 gewählt sind. Auch das Beaufschlagen der Werkstücke mit einem Anpressdruck in Station I zur besseren Vermeidung einer Blasenbildung beim Vorlaminieren wird hier früher und in größerem Ausmaß vorgenommen.

Figur 10 vervollständig sowohl Figur 8 als auch Figur 9 mit einer Station IV, die eine Mehretagen-Kühleinrichtung symbolisiert. Dementsprechend liegt hier die Zieltemperatur 306 bei Raumtemperatur und der Verlauf der Werkstücktemperatur 301 ist abfallend, von der Aushärtetemperatur von nahezu 150 °C auf Raumtemperatur. Der Wärmeübergang von den Kühlplatten (306) zu den Werkstücken (301) wird durch einen Anpressdruck 303 verbessert, weshalb die Mehretagen-Kühleinrichtung (Station IV) als Mehretagen-Presse mit Kühlplatten ausgestaltet ist.

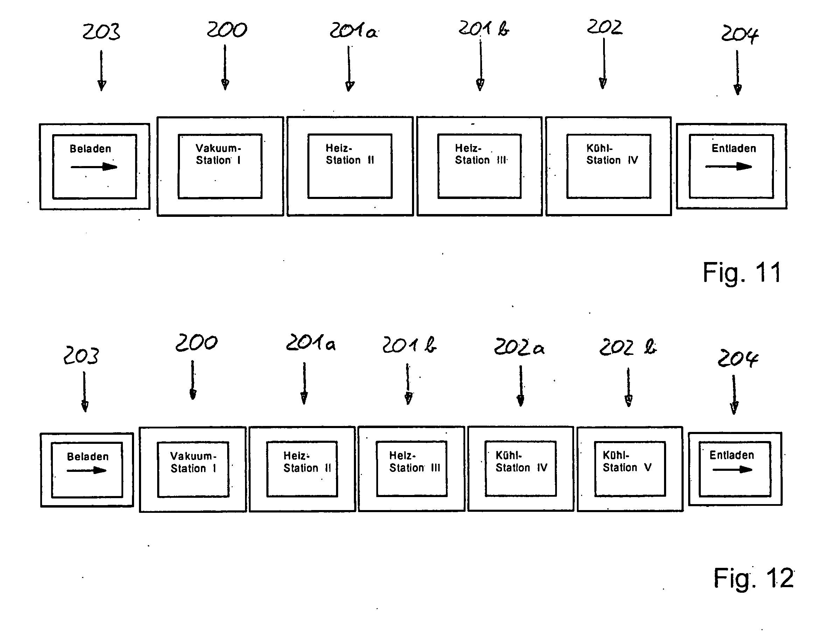

Die Figuren 11 und 12 zeigen schließlich schematisch zwei unterschiedliche Ausführungsbeispiele für eine erfindungsgemäße Vorrichtung, wobei im Ausführungsbeispiel nach Figur 11 einer Mehretagen-Vakuum-Laminierpresse 200 (Vakuumstation I) zwei Mehretagen-Laminatoren 201 a und 201 b (Heizstationen II und III) sowie eine Mehretagen-Kühleinrichtung 202 (Kühlstation IV) nachgeschaltet sind. Zum Beladen der Mehretagen-Vakuum-Laminierpresse 200 ist eine Beschickungsvorrichtung 203 vorgesehen, während zum Entladen der Mehretagen-Kühleinrichtung 202 eine Entladevorrichtung 204 nachgeschaltet ist.

Mit der in Figur 11 dargestellten Produktionslinie können die in den Figuren 8 und 10 bzw. 9 und 10 dargestellten Prozesse gefahren werden. Die in Figur 12 dargestellte Produktionslinie unterscheidet sich hiervon lediglich dadurch, dass statt einer Mehretagen-Kühleinrichtung 202 zwei Mehretagen-Kühleinrichtungen 202a und 202b vorgesehen sind, beispielsweise zur Anpassung der Arbeitstakte an die Mehretagen-Vakuum-Laminierpresse 200, deren Arbeitstakt gegebenenfalls zu kurz ist, um ein Herunterkühlen der fertig laminierten Werkstücke in einer einzigen Kühlstation zu ermöglichen.

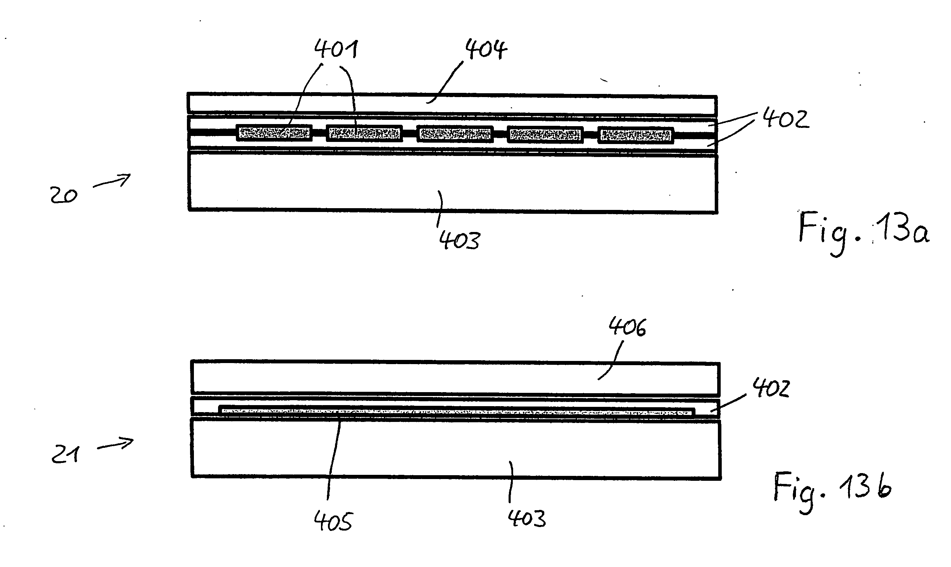

In Figur 13a ist ein Beispiel für ein Werkstück 20 dargestellt, das mit dem erfindungsgemäßen Verfahren laminiert werden soll. Es handelt sich um ein Silizium-Solarzellen-Modul mit einer Anzahl von Silizium-Solarzellen 401, die zwischen zwei Kleberfolien 402 eingebettet sind. Die Vorderseite des Moduls wird durch ein Substratglas 403 gebildet, während auf der Rückseite des Moduls eine Rückseitenfolie 404 aufgelegt ist. Wie anhand dieser Darstellung unmittelbar erkennbar ist, wird das dargestellte Werkstück 20 durch das erfindungsgemäße Verfahren so laminiert, dass das Substratglas 403, die Silizium-Solarzellen 401 und die Rückseitenfolie 404 aufgrund des in den Kleberfolien 402 enthaltenen, vernetzenden Klebers dauerhaft und wetterfest miteinander verbunden werden.

Figur 13b zeigt ein anderes Beispiel für ein zu laminierendes Werkstück 21, das wiederum als Photovoltaik-Modul ausgebildet ist, jedoch eine Dünnschicht-Solarzelle 405 enthält, die zwischen einem Substratglas 403 und einem Rückseitenglas 406 in eine Kleberfolie 402 eingebettet ist. Nach dem Laminiervorgang sind das Substratglas 403 und das Rückseitenglas 406 mit zwischenliegender Dünnschicht-Solarzelle 405 dauerhaft und wetterfest miteinander verbunden.

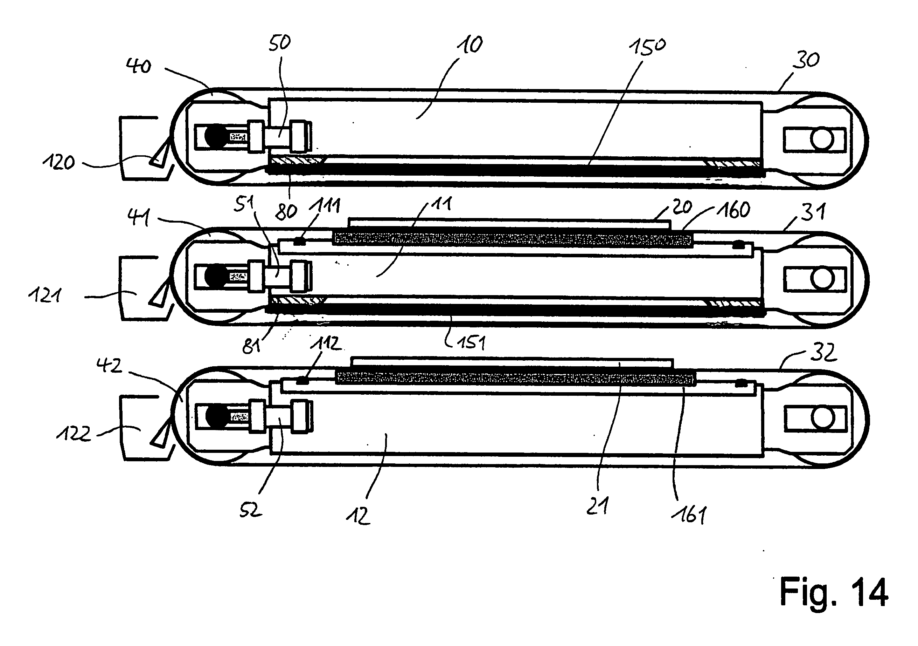

Figur 14 zeigt, wie Figur 1, eine schematische seitliche Teildarstellung von drei Heizplatten 10, 11, 12 einer Mehretagen-Vakuum-Laminierpresse, welche wiederum zwei Pressenetagen mit jeweils einem zu laminierenden Werkstück 20, 21 bilden. Um die Heizplatten 10, 11, 12 läuft wiederum jeweils ein Förderband 30, 31, 32 um, und zwar wiederum um Umlenkrollen 40, 41, 42, die über jeweils eine Kolben-Zylinder-Einheit 50, 51, 52 an den Stirnseiten der Heizplatten 10, 11, 12 befestigt sind und durch Heranfahren an diese Stirnseiten die Förderbänder 30, 31, 32 entspannen können und umgekehrt. An den Umlenkrollen 40, 41, 42 jedes Förderbandes 30, 31, 32 ist jeweils eine Reinigungsvorrichtung 120, 121, 122 angeordnet.

Zur Bildung der Vakuumkammern in den einzelnen Etagen der teilweise dargestellten Mehretagen-Vakuum-Laminierpresse sind wiederum untere Dichtrahmen 111, 112 sowie obere Dichtrahmen 80, 81 vorhanden. Im Unterschied zu dem in Figur 1 dargestellten Ausführungsbeispiel sind hier an den oberen Dichtrahmen 80, 81 allerdings Membrane 150, 151 befestigt, welche die bei geschlossener Presse gebildeten gasdichten Vakuumkammern jeweils in eine Produkthälfte und eine Druckhälfte unterteilen. Die Membrane 150, 151 übernehmen also in konventioneller Weise die Funktion der Untertrums 30b, 31 b, 32b des Ausführungsbeispiels aus Figur 1, so dass im Übrigen auf die zur Figur 1 beschriebene Funktionsweise und den Stand der Technik bei Vakuum-Laminierpressen verwiesen werden darf.

In Figur 14 ist als zusätzliche Modifikation schließlich noch vorgesehen, zwischen den Heizplatten 11,12 und den Werkstücken 20, 21 jeweils ein Druckkissen 160, 161 anzuordnen, um etwaige Unebenheiten oder Toleranzen in der Parallelität der Werkstücke 20, 21 auszugleichen.

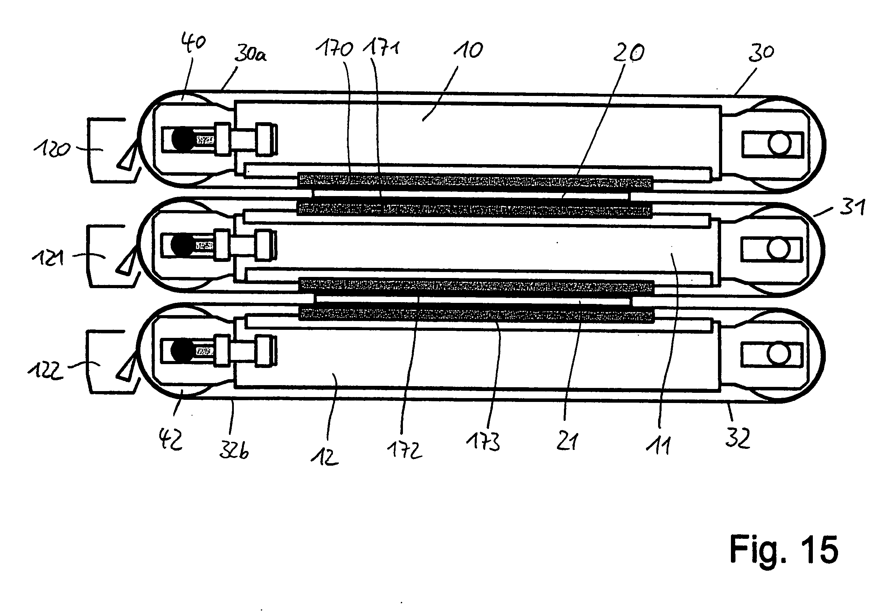

In Figur 15 ist eine weitere Modifikation des in den Figuren 1 und 2 dargestellten Ausführungsbeispiels einer erfindungsgemäßen Vorrichtung dargestellt, wobei die Modifikation darin besteht, dass oberhalb und unterhalb der Werkstücke 20, 21 jeweils ein Polster 170, 171, 172, 173 angebracht ist, das nicht nur zur besseren Druckverteilung dient, sondern auch über definierte Wärmeleit-Eigenschaften verfügt und den Wärmeübergang von den Heizplatten 10, 11, 12 auf die Werkstücke 20, 21 in definierter Weise beeinflusst. Zu den restlichen Merkmalen des hier abgebildeten Ausführungsbeispiels darf auf die vorangegangenen Figurenbeschreibungen verwiesen werden, da funktionsgleiche Elemente mit jeweils gleichen Bezugszeichen versehen sind.

## Patentansprüche

1. Verfahren zum Laminieren von im Wesentlichen plattenförmigen Werkstücken mit mindestens einer durch Wärme aktivierbaren und aushärtbaren Kleberschicht unter Druck- und Wärmeeinwirkung, wobei eine Anzahl von Werkstücken (20, 21) in eine Mehretagen-Vakuum-Laminierpresse (200) eingebracht wird, in welcher die Werkstücke (20, 21) in Pressenetagen mit jeweils einer von einem flexiblen Andrückmittel (30b, 31b. 32b, 150, 151) in eine Produkthälfte (141) und eine Druckhälfte (131) unterteilten Vakuumkammer unter Wärmeeinwirkung laminiert werden, wobei die Produkthälfte (141) der Vakuumkammer, in der mindestens ein Werkstück (20, 21) angeordnet ist, evakuiert wird und das Andrückmittel (30b, 31b, 32b, 150, 151) durch den hierdurch entstehenden Unterdruck und/oder durch ein zusätzliches Druckbeaufschlagen der Druckhälfte (131) der Vakuumkammer, die auf der dem Werkstück (20, 21) abgewandten Seite des Andrückmittels (30b, 31 b, 32b, 150, 151) angeordnet ist, das Werkstück (20, 21) direkt oder indirekt gegen eine Unterseite der Vakuumkammer presst,
wobei der Laminierprozess durch Öffnen der Mehretagen-Vakuum-Laminierpresse (200) unterbrochen wird und die vorlaminierten Werkstücke (20, 21) in einen Mehretagen-Laminator (201) überführt werden, und die Werkstücke (20, 21) im Mehretagen-Laminator (201) unter Druckeinwirkung mit einer Temperatur an oder oberhalb der Aushärtetemperatur der Kleberschichten (402) beaufschlagt werden.

2. Verfahren nach Anspruch 1,
**dadurch gekennzeichnet,**
**dass** als flexibles Andrückmittel Membrane (150, 151) verwendet werden, die jeweils auf einen in jeder Etage der Mehretagen-Vakuum-Laminierpresse (200) vorhandenen Dichtrahmen (80, 81) gespannt sind.

3. Verfahren nach Anspruch 1,
**dadurch gekennzeichnet,**
**dass** eine Mehretagen-Vakuum-Laminierpresse (200) verwendet wird, die eine Anzahl von Heizplatten (10, 11, 12) enthält, wobei jede Heizplatte (10, 11, 12) jeweils ein umlaufendes Förderband (30, 31, 32) mit einem Obertrum (30a, 31 a, 32a) und einem Untertrum (30b, 31 b, 32b) aufweist, und dass jeweils das Untertrum (30b, 31 b, 32b) der Förderbänder (30, 31, 32) als flexibles Andrückmittel in der jeweiligen Etage verwendet wird.

4. Verfahren nach Anspruch 3,
**dadurch gekennzeichnet,**
**dass** Förderbänder (30, 31, 32) verwendet werden, deren Obertrums (30a, 31 a, 32a) jeweils verschieden zu deren Untertrums (30b, 31 b, 32b) ausgebildet sind.

5. Verfahren nach Anspruch 4,
**dadurch gekennzeichnet,**
**dass** zum Be- und Entladen der Mehretagen-Vakuum-Laminierpresse (200) und des Mehretagen-Laminators (201) zunächst die Werkstücke (20, 21) aus letzterem ausgefördert werden, dann in einem zweiten Schritt die Werkstücke (20, 21) aus der Mehretagen-Vakuum-Laminierpresse (200) in den Mehretagen-Laminator (201) überführt werden, und dann in einem dritten Schritt neue Werkstücke (20, 21) in die Mehretagen-Vakuum-Laminierpresse (200) eingefördert werden.

6. Verfahren nach mindestens einem der Ansprüche 1 bis 5,
**dadurch gekennzeichnet,**
**dass** die Werkstücke (20, 21) aus dem Mehretagen-Laminator (201) in eine Mehretagen-Kühleinrichtung (202) zum Kühlen der Werkstücke (20, 21) auf eine Temperatur unterhalb der Erweichungstemperatur der Kleberschichten (402) überführt werden.

7. Verfahren nach mindestens einem der Ansprüche 1 bis 6,
**dadurch gekennzeichnet,**
**dass** in der Mehretagen-Vakuum-Laminierpresse (200) und/oder im Mehretagen-Laminator (201) und/oder in der Mehretagen-Kühleinrichtung (202) zwischen den Werkstücken (20, 21) und den jeweiligen Wärmeaustauschflächen Druckkissen (160, 161) oder Polster (170, 171, 172, 173) eingelegt werden.

8. Verfahren nach mindestens einem der Ansprüche 1 bis 7,
**dadurch gekennzeichnet,**
**dass** zur Beeinflussung der zeitlichen Wärmeeinwirkung auf die Kleberschicht (402) der Werkstücke (20, 21) in der Mehretagen-Vakuum-Laminierpresse (200) und/oder im Mehretagen-Laminator (201) und/oder in der Mehretagen-Kühleinrichtung (202) zwischen den Werkstücken (20, 21) und den jeweiligen Wärmeaustauschflächen Druckkissen (160, 161) oder Polster (170, 171, 172, 173) mit jeweils definierten Wärmeleit-Eigenschaften eingelegt werden.

9. Verfahren nach mindestens einem der Ansprüche 1 bis 8,
**dadurch gekennzeichnet,**
**dass** die Prozesstemperatur in der Mehretagen-Vakuum-Laminierpresse (200) unabhängig vom Mehretagen-Laminator (201) geführt, insbesondere die Zieltemperatur höher oder niedriger eingestellt wird.

10. Verfahren nach Anspruch 9,
**dadurch gekennzeichnet,**
**dass** die Wärmeeinwirkung in der Mehretagen-Vakuum-Laminierpresse (200) auf die Werkstücke (20, 21) so geregelt wird, dass die Kleberschichten (402) erweicht werden und der Laminierprozess beginnt, dass die Temperatur in den Kleberschichten (402) jedoch unter deren Aushärtetemperatur bleibt.

11. Verfahren nach Anspruch 10,
**dadurch gekennzeichnet,**
**dass** zur Regelung der Wärmeeinwirkung in der Mehretagen-Vakuum-Laminierpresse (200) eine Zieltemperatur entsprechend niedrig gewählt oder der Prozess entsprechend frühzeitig abgestoppt wird.

12. Verfahren nach mindestens einem der Ansprüche 9 bis 11,
**dadurch gekennzeichnet,**
**dass** mehrere hintereinandergeschaltete Mehretagen-Laminatoren (201) verwendet werden, deren Zieltemperaturen von Laminator zu Laminator variieren, insbesondere ansteigen.

13. Vorrichtung zum Laminieren von im Wesentlichen plattenförmigen, mit mindestens einer durch Wärme aktivierbaren und aushärtbaren Kleberschicht versehenen Werkstücken unter Druck- und Wärmeeinwirkung, umfassend eine Mehretagen-Vakuum-Laminierpresse (200) mit mehreren Pressenetagen, welche jede eine von einem flexiblen Andrückmittel (30b, 31b, 32b, 150, 151) in eine Produkthälfte (141) und eine Druckhälfte (131) unterteilte Vakuumkammer enthält, wobei die Produkthälfte (141) zur Aufnahme von jeweils mindestens einem Werkstück (20, 21) vorgesehen und evakuierbar ist, während die Druckhälfte (131) druckbeaufschlagbar ist, wobei das flexible Andrückmittel (30b, 31 b, 32b, 150, 151) so ausgestaltet und angeordnet ist, dass es aufgrund eines durch Evakuieren der Produkthälfte (141) und/oder durch ein zusätzliches Druckbeaufschlagen der Druckhälfte (131) vorhandenen Druckunterschieds in der Vakuumkammer das Werkstück (20, 21) direkt oder indirekt gegen eine Unterseite der Vakuumkammer presst,
**dadurch gekennzeichnet,**
**dass** der Mehretagen-Vakuum-Laminierpresse (200) mindestens ein Mehretagen-Laminator (201) mit einer Anzahl von Laminatoretagen nachgeschaltet ist, in denen die Werkstücke (20, 21) unter Druckeinwirkung mit einer Temperatur an oder oberhalb der Aushärtetemperatur der Kleberschichten (402) beaufschlagt werden, und dass eine Transfereinrichtung (30, 31, 32) zum Überführen der Werkstücke (20, 21) von der Mehretagen-Vakuum-Laminierpresse (200) in den Mehretagen-Laminator (201) vorhanden ist.

14. Vorrichtung nach Anspruch 13,
**dadurch gekennzeichnet,**
**dass** dem Mehretagen-Laminator (201) mindestens eine Mehretagen-Kühleinrichtung (202) zum Kühlen der Werkstücke (20, 21) auf eine Temperatur unterhalb der Erweichungstemperatur der Kleberschichten (402) nachgeschaltet ist, wobei eine Transfereinrichtung zum Überführen der Werkstücke (20, 21) vom Mehretagen-Laminator (201) in die Mehretagen-Kühleinrichtung (202) vorhanden ist.

15. Vorrichtung nach einem der Ansprüche 13 oder 14,
**dadurch gekennzeichnet,**
**dass** die flexiblen Andrückmittel in den Vakuumkammern der Mehretagen-Vakuum-Laminierpresse (200) als elastische Membrane (150, 151) ausgestaltet sind, welche jeweils auf einen in jeder Etage der Mehretagen-Vakuum-Laminierpresse (200) vorgesehenen Dichtrahmen (80, 81) gespannt sind.

16. Vorrichtung nach einem der Ansprüche 13 oder 14,
**dadurch gekennzeichnet,**
**dass** die Mehretagen-Vakuum-Laminierpresse (200) eine Anzahl von Heizplatten (10, 11, 12) umfasst, wobei jede Heizplatte (10, 11, 12) mit jeweils einem umlaufenden Förderband (30, 31, 32) mit einem Obertrum (30a, 31a, 32a) und einem Untertrum (30b, 31 b, 32b) versehen ist, und wobei jeweils das Untertrum (30b, 31b, 32b) der Förderbänder (30, 31, 32) als flexibles Andrückmittel in der jeweiligen Etage fungiert.

17. Vorrichtung nach Anspruch 16,
**dadurch gekennzeichnet,**
**dass** die Obertrums (30a, 31a, 32a) und die Untertrums (30b, 31b, 32b) jedes Förderbandes (30, 31, 32) jeweils verschieden ausgebildet sind.

18. Vorrichtung nach mindestens einem der Ansprüche 13 bis 17,
**dadurch gekennzeichnet,**
**dass** in der Mehretagen-Vakuum-Laminierpresse (200) und/oder im Mehretagen-Laminator (201) und/oder in der Mehretagen-Kühleinrichtung (202) den Werkstücken (20, 21) Druckkissen (160, 161) oder Polster (170, 171, 172, 173) unterlegt sind und/oder auf die Werkstücke (20, 21) Druckkissen (160, 161) oder Polster (170, 171, 172, 173) aufgelegt sind.

19. Vorrichtung nach Anspruch 18,
**dadurch gekennzeichnet,**
**dass** die Druckkissen (160, 161) oder Polster (170, 171, 172, 173) zur Beeinflussung der zeitlichen Wärmeeinwirkung auf die Kleberschicht (402) der Werkstücke (20, 21) jeweils definierte Wärmeleit-Eigenschaften aufweisen.

20. Vorrichtung nach mindestens einem der Ansprüche 13 bis 19,
**dadurch gekennzeichnet,**
**dass** die Prozesstemperatur in der Mehretagen-Vakuum-Laminierpresse (200) unabhängig vom Mehretagen-Laminator (201) führbar ist, insbesondere dadurch, dass die Zieltemperatur höher oder niedriger einstellbar ist.

21. Vorrichtung nach Anspruch 20,
**dadurch gekennzeichnet,**
**dass** die Wärmeeinwirkung auf die Werkstücke (20, 21) in der Mehretagen-Vakuum-Laminierpresse (200) so regelbar ist, dass die Kleberschichten (402) erweicht werden und der Laminierprozess beginnt, dass die Temperatur in den Kleberschichten (402) jedoch unter deren Aushärtetemperatur bleibt.

22. Vorrichtung nach einem der Ansprüche 20 oder 21,
**dadurch gekennzeichnet,**
**dass** mehrere Mehretagen-Laminatoren (201a, 201b) hintereinander geschaltet sind.

## Claims

1. Method of laminating substantially plate-like workpieces having at least one heat activatable and hardenable adhesive layer under the action of pressure and heat, a number of workpieces (20, 21) being introduced into a multi-level vacuum laminating press (200), in which the workpieces (20, 21) are laminated under the action of heat in press levels each having a vacuum chamber divided by a flexible pressing means (30b, 31b, 32b, 150, 151) into a product half (141) and a pressure half (131), wherein the product half (141) of the vacuum chamber, in which at least one workpiece (20, 21) is arranged, is evacuated and the pressing means (30b, 31b, 32b, 150, 151), as a result of the reduced pressure thereby produced and/or as a result of additional application of pressure to the pressure half (131) of the vacuum chamber, which is arranged on the side of the pressing means (30b, 31 b, 32b, 150, 151) remote from the workpiece (20, 21), presses the workpiece (20, 21) directly or indirectly against the underside of the vacuum chamber,
wherein the laminating process is interrupted by opening of the multi-level vacuum laminating press (200) and the prelaminated workpieces (20, 21) are transferred into a multi-level laminator (201), and the workpieces (20, 21) in the multi-level laminator (201), under the action of pressure, are subjected to a temperature at or above the hardening temperature of the adhesive layers (402).

2. Method according to claim 1,
**characterised in that**
as flexible pressing means there are used membranes (150, 151) which are each mounted under tension on a sealing frame (80, 81) present in each level of the multi-level vacuum laminating press (200).

3. Method according to claim 1,
**characterised in that**
a multi-level vacuum laminating press (200) is used which contains a number of heating plates (10, 11, 12), each heating plate (10, 11, 12) having a respective circulating conveyor belt (30, 31, 32) having an upper run (30a, 31 a, 32a) and a lower run (30b, 31 b, 32b), and the lower run (30b, 31 b, 32b) of each of the conveyor belts (30, 31, 32) is used as flexible pressing means in the respective level.

4. Method according to claim 3,
**characterised in that**
there are used conveyor belts (30, 31, 32) the upper runs (30a, 31 a, 32a) of which are each constructed differently from the lower runs (30b, 31 b, 32b) thereof.

5. Method according to claim 4,
**characterised in that**
for loading and unloading the multi-level vacuum laminating press (200) and the multi-level laminator (201), the workpieces (20, 21) are first transported out of the latter, then in a second step the workpieces (20, 21) are transferred from the multi-level vacuum laminating press (200) into the multi-level laminator (201), and then in a third step fresh workpieces (20, 21) are transported into the multi-level vacuum laminating press (200).

6. Method according to at least one of claims 1 to 5,
**characterised in that**
the workpieces (20, 21) are transferred from the multi-level laminator (201) into a multi-level cooling device (202) for cooling the workpieces (20, 21) to a temperature below the softening temperature of the adhesive layers (402).

7. Method according to at least one of claims 1 to 6,
**characterised in that**
in the multi-level vacuum laminating press (200) and/or in the multi-level laminator (201) and/or in the multi-level cooling device (202), pressure pads (160, 161) or cushions (170, 171, 172, 173) are inserted between the workpieces (20, 21) and the respective heat exchange surfaces.

8. Method according to at least one of claims 1 to 7,
**characterised in that**
to influence the action of heat over time on the adhesive layer (402) of the workpieces (20, 21) in the multi-level vacuum laminating press (200) and/or in the multi-level laminator (201) and/or in the multi-level cooling device (202), pressure pads (160, 161) or cushions (170, 171, 172, 173) each having defined heat-conducting properties are inserted between the workpieces (20, 21) and the respective heat exchange surfaces.

9. Method according to at least one of claims 1 to 8,
**characterised in that**
the process temperature in the multi-level vacuum laminating press (200) is controlled independently of the multi-level laminator (201), especially the target temperature is set to a higher or lower value.

10. Method according to claim 9,
**characterised in that**
the action of heat on the workpieces (20, 21) in the multi-level vacuum laminating press (200) is regulated in such a way that the adhesive layers (402) are softened and the laminating process begins, but the temperature in the adhesive layers (402) remains below the hardening temperature thereof.

11. Method according to claim 10,
**characterised in that**
for regulating the action of heat in the multi-level vacuum laminating press (200), a target temperature is selected to be correspondingly low or the process is stopped correspondingly early.

12. Method according to at least one of claims 9 to 11,
**characterised in that**
a plurality of multi-level laminators (201) arranged in series are used, the target temperatures of which vary, especially rise, from laminator to laminator.

13. Apparatus for laminating substantially plate-like workpieces provided with at least one heat activatable and hardenable adhesive layer under the action of pressure and heat, comprising a multi-level vacuum laminating press (200) having a plurality of press levels each of which contains a vacuum chamber divided by a flexible pressing means (30b, 31b, 32b, 150, 151) into a product half (141) and a pressure half (131), the product half (141) being provided for receiving at least one workpiece (20, 21) and being evacuatable, while the pressure half (131) is arranged to be acted upon by pressure, the flexible pressing means (30b, 31b, 32b, 150, 151) being so configured and arranged that, as a result of a pressure difference in the vacuum chamber caused by evacuation of the product half (141) and/or by additional application of pressure to the pressure half (131), it presses the workpiece (20, 21) directly or indirectly against the underside of the vacuum chamber,
**characterised in that**
downstream of the multi-level vacuum laminating press (200) there is arranged at least one multi-level laminator (201) having a number of laminator levels in which the workpieces (20, 21), under the action of pressure, are acted upon by a temperature at or above the hardening temperature of the adhesive layers (402), and a transfer device (30, 31, 32) is provided for transferring the workpieces (20, 21) from the multi-level vacuum laminating press (200) into the multi-level laminator (201).

14. Apparatus according to claim 13,
**characterised in that**
downstream of the multi-level laminator (201) there is arranged at least one multi-level cooling device (202) for cooling the workpieces (20, 21) to a temperature below the softening temperature of the adhesive layers (402), a transfer device being provided for transferring the workpieces (20, 21) from the multi-level laminator (201) into the multi-level cooling device (202).

15. Apparatus according to either one of claims 13 and 14,
**characterised in that**
the flexible pressing means in the vacuum chambers of the multi-level vacuum laminating press (200) are in the form of resilient membranes (150, 151) which are each mounted under tension on a sealing frame (80, 81) provided in each level of the multi-level vacuum laminating press (200).

16. Apparatus according to either one of claims 13 and 14,
**characterised in that**
the multi-level vacuum laminating press (200) comprises a number of heating plates (10, 11, 12), each heating plate (10, 11, 12) being provided with a respective circulating conveyor belt (30, 31, 32) having an upper run (30a, 31 a, 32a) and a lower run (30b, 31 b, 32b), and the lower run (30b, 31 b, 32b) of each of the conveyor belts (30, 31, 32) acting as flexible pressing means in the respective level.

17. Apparatus according to claim 16,
**characterised in that**
the upper runs (30a, 31 a, 32a) and the lower runs (30b, 31 b, 32b) of each conveyor belt (30, 31, 32) are each differently constructed.

18. Apparatus according to at least one of claims 13 to 17,
**characterised in that**
in the multi-level vacuum laminating press (200) and/or in the multi-level laminator (201) and/or in the multi-level cooling device (202), pressure pads (160, 161) or cushions (170, 171, 172, 173) are positioned below the workpieces (20, 21) and/or pressure pads (160, 161) or cushions (170, 171, 172, 173) are positioned on top of the workpieces (20, 21).

19. Apparatus according to claim 18,
**characterised in that**
the pressure pads (160, 161) or cushions (170, 171, 172, 173) each have defined heat-conducting properties for influencing the action of heat over time on the adhesive layer (402) of the workpieces (20,21).

20. Apparatus according to at least one of claims 13 to 19,
**characterised in that**
the process temperature in the multi-level vacuum laminating press (200) is controllable independently of the multi-level laminator (201), especially by the target temperature's being settable to a higher or lower value.

21. Apparatus according to claim 20,
**characterised in that**
the action of heat on the workpieces (20, 21) in the multi-level vacuum laminating press (200) is regulatable in such a way that the adhesive layers (402) are softened and the laminating process begins, but the temperature in the adhesive layers (402) remains below the hardening temperature thereof.

22. Apparatus according to either one of claims 20 and 21,
**characterised in that**
a plurality of multi-level laminators (201 a, 201 b) are arranged in series.

## Revendications

1. Procédé de stratification, sous l'action de pression et de chaleur, de pièces essentiellement en formes de plaques pourvues d'au moins une couche d'adhésif activable et durcissable par la chaleur, sachant qu'on introduit un certain nombre de pièces (20, 21) dans une presse à stratifier (200) à vide à plusieurs étages, dans laquelle les pièces (20, 21) sont stratifiées sous l'action de chaleur dans des étages de presse pourvus chacun d'une chambre à vide divisée par un moyen presseur flexible (30b, 31b, 32b, 150, 151) en une moitié de produit (141) et une moitié de pression (131), sachant que la moitié de produit (141) de la chambre à vide, dans laquelle est disposée au moins une pièce (20, 21), est mise au vide et que le moyen presseur (30b, 31b, 32b, 150, 151), par la dépression ainsi produite et/ou par une pressurisation supplémentaire de la moitié de pression (131) de la chambre à vide - moitié qui est disposée sur le côté du moyen presseur (30b, 31b, 32b, 150, 151) qui est opposé à la pièce (20, 21) -, presse la pièce (20, 21) directement ou indirectement contre un côté inférieur de la chambre à vide, sachant que le processus de stratification est interrompu en ouvrant la presse à stratifier (200) à vide à plusieurs étages et les pièces pré-stratifiées (20, 21) sont transférées dans une machine à stratifier (201) à plusieurs étages, et que les pièces (20, 21) sont, dans la machine à stratifier (201) à plusieurs étages, sollicitées sous l'action de pression à une température égale ou supérieure à la température de durcissement des couches d'adhésif (402).

2. Procédé selon la revendication 1, **caractérisé en ce qu'**on utilise comme moyen presseur flexible des membranes (150, 151), qui sont respectivement tendues sur un cadre d'étanchéité (80, 81) présent dans chaque étage de la presse à stratifier (200) à vide à plusieurs étages.

3. Procédé selon la revendication 1, **caractérisé en ce qu'**on utilise une presse à stratifier (200) à vide à plusieurs étages qui contient un certain nombre de plaques chauffantes (10, 11, 12), chaque plaque chauffante (10, 11, 12) présentant respectivement une bande transporteuse circulante (30, 31, 32) ayant un brin supérieur (30a, 31a, 32a) et un brin inférieur (30b, 31b, 32b), et **en ce que** le brin inférieur (30b, 31b, 32b) des bandes transporteuses (30, 31, 32) est respectivement utilisé comme moyen presseur flexible dans l'étage respectif.

4. Procédé selon la revendication 3, **caractérisé en ce qu'**on utilise des bandes transporteuses (30, 31, 32) dont les brins supérieurs (30a, 31a, 32a) sont respectivement d'une configuration différente de celle de leurs brins inférieurs (30b, 3 1 b, 32b).

5. Procédé selon la revendication 4, **caractérisé en ce que**, pour le chargement et le déchargement de la presse à stratifier (200) à vide à plusieurs étages et la machine à stratifier (201) à plusieurs étages, des pièces (20, 21) sont d'abord évacuées de cette dernière puis, au cours d'une deuxième étape, des pièces (20, 21) sont transférées de la presse à stratifier (200) à vide à plusieurs étages dans la machine à stratifier (201) à plusieurs étages et enfin, au cours d'une troisième étape, de nouvelles pièces (20, 21) sont chargées dans la presse à stratifier (200) à vide à plusieurs étages.

6. Procédé selon au moins une des revendications 1 à 5, **caractérisé en ce que** les pièces (20, 21) sont transférées de la machine à stratifier (201) à plusieurs étages dans un dispositif de refroidissement (202) à plusieurs étages, pour refroidir les pièces (20, 21) à une température inférieure à la température de ramollissement des couches d'adhésif (402).

7. Procédé selon au moins une des revendications 1 à 6, **caractérisé en ce que** des coussins de pression (160, 161) ou des rembourrages (170, 171, 172, 173) sont insérés entre les pièces (20, 21) et les surfaces d'échange de chaleur respectives dans la presse à stratifier (200) à vide à plusieurs étages et/ou dans la machine à stratifier (201) à plusieurs étages et/ou dans le dispositif de refroidissement (202) à plusieurs étages.

8. Procédé selon au moins une des revendications 1 à 7, **caractérisé en ce que**, afin d'agir sur l'évolution dans le temps de l'action de la chaleur sur la couche d'adhésif (402) des pièces (20, 21), des coussins de pression (160, 161) ou des rembourrages (170, 171, 172, 173) ayant des propriétés respectives définies de conduction de chaleur sont insérés entre les pièces (20, 21) et les surfaces d'échange de chaleur respectives dans la presse à stratifier (200) à vide à plusieurs étages et/ou dans la machine à stratifier (201) à plusieurs étages et/ou dans le dispositif de refroidissement (202) à plusieurs étages.

9. Procédé selon au moins une des revendications 1 à 8, **caractérisé en ce que** la température du processus dans la presse à stratifier (200) à vide à plusieurs étages est commandée indépendamment de la machine à stratifier (201) à plusieurs étages, en particulier la température cible est réglée plus haute ou plus basse.

10. Procédé selon la revendication 9, **caractérisé en ce que** l'action de la chaleur sur les pièces (20, 21) dans la presse à stratifier (200) à vide à plusieurs étages est régulée de telle sorte que les couches d'adhésif (402) sont ramollies et que le processus de stratification commence, mais que la température dans les couches d'adhésif (402) reste inférieure à leur température de durcissement.

11. Procédé selon la revendication 10, **caractérisé en ce que**, pour la régulation de l'action de la chaleur dans la presse à stratifier (200) à vide à plusieurs étages, on choisit une température cible abaissée d'une manière correspondante, ou on arrête le processus d'autant plus tôt.

12. Procédé selon au moins une des revendications 9 à 11, **caractérisé en ce qu'**on utilise plusieurs machines à stratifier (201) à plusieurs étages montées en série, dont les températures cibles varient, notamment augmentent, d'une machine à stratifier à l'autre.

13. Dispositif de stratification, sous l'action de pression et de chaleur, de pièces essentiellement en formes de plaques pourvues d'au moins une couche d'adhésif activable et durcissable par la chaleur, comprenant une presse à stratifier (200) à vide à plusieurs étages, dotée de plusieurs étages de presse qui contiennent chacun une chambre à vide divisée par un moyen presseur flexible (30b, 31b, 32b, 150, 151) en une moitié de produit (141) et une moitié de pression (131), sachant que la moitié de produit (141) est prévue pour recevoir respectivement au moins une pièce (20, 21) et peut être mise au vide, tandis que la moitié de pression (131) peut être pressurisée, et sachant que le moyen presseur flexible (30b, 31b, 32b, 150, 151) est configuré et disposé de telle sorte que, en raison d'une différence de pression présente dans la chambre à vide du fait de la mise au vide de la moitié de produit (141) et/ou d'une pressurisation supplémentaire de la moitié de pression (131), il presse la pièce (20, 21) directement ou indirectement contre un côté inférieur de la chambre à vide,
**caractérisé en ce que** la presse à stratifier (200) à vide à plusieurs étages est suivie d'au moins une machine à stratifier (201) à plusieurs étages comprenant un certain nombre d'étages de machine à stratifier dans lesquels les pièces (20, 21) sont sollicitées sous l'action de pression à une température égale ou supérieure à la température de durcissement des couches d'adhésif (402), et **en ce qu'**un dispositif de transfert (30, 31, 32) est présent pour transférer les pièces (20, 21) de la presse à stratifier (200) à vide à plusieurs étages dans la machine à stratifier (201) à plusieurs étages.

14. Dispositif selon la revendication 13, **caractérisé en ce que** la machine à stratifier (201) à plusieurs étages est suivie d'au moins un dispositif de refroidissement (202) à plusieurs étages pour refroidir les pièces (20, 21) à une température inférieure à la température de ramollissement des couches d'adhésif (402), sachant qu'un dispositif de transfert est présent pour transférer les pièces (20, 21) de la machine à stratifier (201) à plusieurs étages dans le dispositif de refroidissement (202) à plusieurs étages.

15. Dispositif selon la revendication 13 ou 14, **caractérisé en ce que** les moyens presseurs flexibles dans les chambres à vide de la presse à stratifier (200) à vide à plusieurs étages sont réalisés sous la forme de membranes élastiques (150, 151) qui sont respectivement tendues sur un cadre d'étanchéité (80, 81) prévu dans chaque étage de la presse à stratifier (200) à vide à plusieurs étages.

16. Dispositif selon la revendication 13 ou 14, **caractérisé en ce que** la presse à stratifier (200) à vide à plusieurs étages comprend un certain nombre de plaques chauffantes (10, 11, 12), sachant que chaque plaque chauffante (10, 11, 12) est respectivement pourvue d'une bande transporteuse circulante (30, 31, 32) ayant un brin supérieur (30a, 31a, 32a) et un brin inférieur (30b, 31b, 32b), et sachant que le brin inférieur (30b, 31b, 32b) des bandes transporteuses (30, 31, 32) sert respectivement de moyen presseur flexible dans l'étage respectif.

17. Dispositif selon la revendication 16, **caractérisé en ce que** les brins supérieurs (30a, 31a, 32a) et les brins inférieurs (30b, 31b, 32b) de chaque bande transporteuse (30, 31, 32) sont respectivement d'une configuration différente.

18. Dispositif selon au moins une des revendications 13 à 17, **caractérisé en ce que**, dans la presse à stratifier (200) à vide à plusieurs étages et/ou dans la machine à stratifier (201) à plusieurs étages et/ou dans le dispositif de refroidissement (202) à plusieurs étages, des coussins de pression (160, 161) ou des rembourrages (170, 171, 172, 173) sont placés sous les pièces (20, 21), et/ou des coussins de pression (160, 161) ou des rembourrages (170, 171, 172, 173) sont placés sur les pièces (20, 21).

19. Dispositif selon la revendication 18, **caractérisé en ce que** les coussins de pression (160, 161) ou rembourrages (170, 171, 172, 173) présentent, afin d'agir sur l'évolution dans le temps de l'action de la chaleur sur la couche d'adhésif (402) des pièces (20, 21), des propriétés respectives définies de conduction de chaleur.

20. Dispositif selon au moins une des revendications 13 à 19, **caractérisé en ce que** la température du processus dans la presse à stratifier (200) à vide à plusieurs étages peut être commandée indépendamment de la machine à stratifier (201) à plusieurs étages, en particulier par le fait que la température cible peut être réglée plus haute ou plus basse.

21. Dispositif selon la revendication 20, **caractérisé en ce que** l'action de la chaleur sur les pièces (20, 21) dans la presse à stratifier (200) à vide à plusieurs étages peut être régulée de telle sorte que les couches d'adhésif (402) soient ramollies et que le processus de stratification commence, mais que la température dans les couches d'adhésif (402) reste inférieure à leur température de durcissement.

22. Dispositif selon la revendication 20 ou 21, **caractérisé en ce que** plusieurs machines à stratifier (201a, 201b) à plusieurs étages sont montées en série.
